# EUROPEAN PATENT APPLICATION

(11) **EP 2 416 391 A2**
(43) Date of publication of application: **08.02.2012**
(21) Application number: 11176721.6
(22) Date of filing: 05.08.2011
(51) Int. Cl.: H01L 45/00

(54) **Nonvolatile memory elements and memory devices including the same**

(30) Priority: 06.08.2010 KR 20100075982
(71) Applicant: SAMSUNG ELECTRONICS CO., LTD., Suwon-si Gyeonggi-do 442-742 (KR)
(72) Inventor: Lee, Seung-ryul, 449-712 Gyeonggi-do (KR); Kim, Chang-jung, 449-712 Gyeonggi-do (KR); Kim, Young-bae, 449-712 Gyeonggi-do (KR); Lee, Myoung-jae, 449-712 Gyeonggi-do (KR); Hur, Ji-hyun, 449-712 Gyeonggi-do (KR); Lee, Dong-soo, 449-712 Gyeonggi-do (KR); Chang, Man, 449-712 Gyeonggi-do (KR); Lee, Chang-bum, 449-712 Gyeonggi-do (KR)
(74) Representative: Zijlstra, Robert Wiebo Johan

(57) **Abstract**

Nonvolatile memory elements may include a first electrode, a second electrode, a first buffer layer, a second buffer layer and a memory layer. The memory layer may be between the first and second electrodes. The first butter layer may be between the memory layer and the first electrode. The second buffer layer may be between the memory layer and the second electrode. The memory layer may be a multi-layer structure including a first material layer and a second material layer. The first material layer may include a first metal oxide which is of the same group as, or a different group from, a second metal oxide included in the second material layer.

## Description

### BACKGROUND

Example embodiments are related to nonvolatile memory elements, memory devices including the nonvolatile memory elements and/or methods of forming the nonvolatile memory elements.

Nonvolatile memory devices generally include a magnetic random access memory (MRAM), a ferroelectric RAM (FRAM), a phase-change RAM (PRAM), a resistive RAM (RRAM), or the like. Among them, the RRAM is a resistive memory device that stores data based on a resistance change of a material. In the RRAM, the resistance of a resistance-change material is changed from a high-resistance state to a low-resistance state ("ON state") when a voltage applied to the resistance-change material is greater than or equal to a set voltage. The resistance of the resistance-change material is switched back to the high-resistance state ("OFF state") when a voltage applied to the resistance-change material is greater than or equal to a reset voltage.

A nonvolatile memory device may be bipolar and/or unipolar. A bipolar device switches between states using both a positive and a negative voltage. A unipolar device switches between each state using only one voltage polarity. Generally, a resistive memory device includes a storage node and a switching device. The storage node includes a resistance-change material layer. The switching device is electrically connected to the storage node and controls access of a signal to the storage node.

The need for high density and high performance nonvolatile memory devices, such as resistive memory devices described above, are continuously increasing.

### SUMMARY

Some example embodiments may provide nonvolatile memory elements using resistance change. Some example embodiments may provide memory devices including the nonvolatile memory elements.

According to at least one example embodiment, a nonvolatile memory element includes a first electrode, a second electrode, a first buffer layer disposed between the first electrode and the second electrode, a second buffer layer disposed between the second electrode and the first buffer layer, and a memory layer disposed between the first buffer layer and the second buffer layer, the memory layer having a resistance change characteristic.

The memory layer may include a first material layer and a second material layer. The first material layer may be formed of a first metal oxide. The first metal oxide may contain at least one of a Ta oxide, a Zr oxide, an yttria-stabilized zirconia (YSZ), a Ti oxide, a Hf oxide, a Mn oxide, a Mg oxide, and a combination thereof. The first metal oxide may contain TaOₓ, for example. Here, x may satisfy a condition 0 < x < 2.5 or a condition 0.5 ≤ x ≤ 2.0. The second material layer may be formed of a second metal oxide. The second metal oxide may contain at least one of a Ta oxide, a Zr oxide, an YSZ, a Ti oxide, a Hf oxide, a Mn oxide, a Mg oxide, and a combination thereof. The oxygen concentration of the second material layer may be higher than that of the first material layer.

The oxygen mobility of the second material layer may be equal to or greater than that of the first material layer. The resistance change characteristic of the memory layer may be due to movements of ion species between the first material layer and the second material layer. The thickness of the first material layer may be about 1 nm to about 100 nm, whereas the thickness of the second material layer may be about 1 nm to about 50 nm. The thickness of the first material layer may be greater than the thickness of the second material layer. At least one of the first and second buffer layers may contain a material having greater interatomic bonding energy than the memory layer. At least one of the first and second buffer layers may contain a material raising a potential barrier between the memory layer and the first electrode or between the memory layer and the second electrode.

At least one of the first and second buffer layers may contain a material having higher resistivity than the memory layer. The first and second buffer layers may contact the first and second material layers, respectively. At least one of the first and second buffer layers may contain at least one of AlOₓ, SiOₓ, SiNₓ, ZrOₓ, HfOₓ, and a combination thereof. The first and second buffer layers may have thicknesses below about 10 nm. Here, the thickness of the first material layer may be about 5 nm to about 50 nm, the thickness of the second material layer may be about 5 nm to about 20 nm, and the thickness of the first material layer may be greater than the thickness of the second material layer. At least one of the first and second electrodes may include at least one of Pt, lr, Pd, Au, Ru, Ti, Ta, TiN, TiW, TaN, W, Ni, a conductive oxide, and an alloy thereof.

According to some example embodiments, a memory device includes the nonvolatile memory element as described above. The memory device may further include a switching element connected to the nonvolatile memory element.

According to other example embodiments, a memory device includes a plurality of first wirings arranged in parallel to each other, a plurality of second wirings arranged in parallel to each other and crossing the first wirings to form a plurality of cross-points, and a plurality of memory cells, each of the memory cells being arranged at one of the cross-points. Each of the memory cells include a first buffer layer disposed between the first wiring and the second wiring, a memory layer disposed between the first buffer layer and the second wiring and having a resistance change characteristic, and a second buffer layer disposed between the memory layer and the second wiring. Each of the memory cells may further include an intermediate electrode contacting the second buffer layer and a switching element disposed between the intermediate electrode and the second wiring.

The memory layer may include a first material layer and a second material layer. The first material layer may be formed of a first metal oxide. The first metal oxide may contain at least one of a Ta oxide, a Zr oxide, an yttria-stabilized zirconia (YSZ), a Ti oxide, a Hf oxide, a Mn oxide, a Mg oxide, and a combination thereof. The first metal oxide may contain TaOₓ, for example. Here, x may satisfy a condition 0 < x < 2.5 or a condition 0.5 ≤ x ≤ 2.0. The second material layer may be formed of a second metal oxide. The second metal oxide may contain at least one of a Ta oxide, a Zr oxide, an YSZ, a Ti oxide, a Hf oxide, a Mn oxide, a Mg oxide, and a combination thereof. The resistance change characteristic of the memory layer may be due to movements of ion species between the first material layer and the second material layer. At least one of the first and second buffer layers may contain at least one of AlOₓ, SiOₓ, SiNₓ, ZrOₓ, HfOₓ, and a combination thereof.

The memory device may further include a plurality of third wirings arranged on the second wirings so as to cross the second wirings and form a plurality of second cross-points, and a plurality of second memory cells, each of the second memory cells being arranged at one of the second cross-points. Each of the second memory cells may include a third buffer layer disposed between the second wiring and the third wiring, a second memory layer disposed between the third buffer layer and the third wiring, the second memory layer including a third and a fourth material layers and having a resistance change characteristic, and a fourth buffer layer disposed between the second memory layer and the third wiring. Each of the second memory cells may further include a second switching element disposed between the second wiring and the third buffer layer and a second intermediate electrode disposed adjacent to the third buffer layer. The resistance change characteristic of the second memory layer may be due to movements of ion species between the third material layer and the fourth material layer.

According to at least one example embodiment, a nonvolatile memory element includes a first electrode, a second electrode, a memory layer with a resistance change characteristic between the first and second electrodes, a first buffer layer between the first electrode and the memory layer and a second buffer layer between the second electrode and the memory layer.

According to at least one example embodiment, a memory device includes a plurality of first wirings, a plurality of second wirings crossing the first wirings, a plurality of first cross-points between the first and second wirings and a plurality of memory cells, each of the memory cells at one of the first cross-points or at a different one of the first cross-points, and including a memory layer with a resistance change characteristic between one of the first wirings and a first one of the second wirings, a first buffer layer between the memory layer and the one of the first wirings, and a second buffer layer between the memory layer and the first one of the second wirings.

According to at least one example embodiment, a memory element includes first and second reactive layers, first and second ion conduction layers between the first and second reactive layers, the first and second ion conduction layers configured to conduct ions in response to a voltage, a first buffer layer between the first reactive layer and the first ion conduction layer, and a second buffer layer between the second reactive layer and the second ion conduction layer.

### BRIEF DESCRIPTION OF THE DRAWINGS

Example embodiments will be more clearly understood from the following brief description taken in conjunction with the accompanying drawings. FIGS. 1-9 represent non-limiting, example embodiments as described herein.
FIG. 1 is a cross-sectional diagram of nonvolatile memory elements according to some example embodiments;
FIGS. 2A and 2B are schematic views illustrating the operation mechanism of a memory cell according to at least one example embodiment;
FIG. 3 is a graph illustrating voltage-current characteristics of memory elements with a (Pt/ TaOₓ/ Ta₂O₅/ Pt) structure according to a comparative example;
FIG. 4 is a graph illustrating voltage-current characteristics of memory elements with a (W/ Al₂O₃/ TaOₓ/ Ta₂O₅/ Ru) structure according to another comparative example;
FIG. 5 is a graph illustrating voltage-current characteristics of memory elements with a (W/ Al₂O₃/ TaOₓ/ Ta₂O₅/ Al₂O₃/ Ru) structure according to at least one example embodiment;
FIG. 6 is a graph illustrating ON/OFF current as a function of a number of switching operations of a memory element with the (W/ Al₂O₃/ TaOₓ/ Ta₂O₅/ Al₂O₃/ Ru) structure of Fig. 5;
FIG. 7 is a perspective view of a memory device including a non-volatile memory element according to further example embodiments;
FIG. 8 is a schematic diagram illustrating memory cards according to example embodiments; and
FIG. 9 is a block diagram illustrating electronic systems according to example embodiments.

It should be noted that these figures are intended to illustrate the general characteristics of methods, structure and/or materials utilized in certain example embodiments and to supplement the written description provided below. These drawings are not, however, to scale and may not precisely reflect the precise structural or performance characteristics of any given embodiment, and should not be interpreted as defining or limiting the range of values or properties encompassed by example embodiments. For example, the relative thicknesses and positioning of molecules, layers, regions and/or structural elements may be reduced or exaggerated for clarity. The use of similar or identical reference numbers in the various drawings is intended to indicate the presence of a similar or identical element or feature.

### DETAILED DESCRIPTION

Various example embodiments will now be described more fully with reference to the accompanying drawings in which example embodiments are shown. Example embodiments may, however, be embodied in many different forms and should not be construed as being limited to the embodiments set forth herein; rather, these embodiments are provided so that this disclosure will be thorough and complete, and will fully convey the concept of example embodiments to those of ordinary skill in the art. In the drawings, the thicknesses of layers and regions are exaggerated for clarity. Like reference numerals in the drawings denote like elements, and thus their description will be omitted.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. As used herein the term "and/or" includes any and all combinations of one or more of the associated listed items. Other words used to describe the relationship between elements or layers should be interpreted in a like fashion (e.g., "between" versus "directly between," "adjacent" versus "directly adjacent," "on" versus "directly on").

It will be understood that, although the terms "first", "second", etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of example embodiments.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises" and/or "comprising," "includes" and/or "including," if used in this specification, specify the presence of stated features, integers, steps, operations, elements, and/or components, but do not preclude the presence or addition of one or more other features, integers, steps, operations, elements, components, and/or groups thereof.

Example embodiments are described herein with reference to cross-sectional illustrations that are schematic illustrations of idealized embodiments (and intermediate structures) of example embodiments. As such, variations from the shapes of the illustrations as a result, for example, of manufacturing techniques and/or tolerances, are to be expected. Thus, example embodiments should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of example embodiments.

Unless otherwise defined, all terms (including technical and scientific terms) used herein have the same meaning as commonly understood by one of ordinary skill in the art to which example embodiments belong. It will be further understood that terms, such as those defined in commonly-used dictionaries, should be interpreted as having a meaning that is consistent with their meaning in the context of the relevant art and will not be interpreted in an idealized or overly formal sense unless expressly so defined herein. Like reference numerals in the drawings denote like elements throughout the description of the figures.

Reference will now be made to example embodiments, some of which are illustrated in the accompanying drawings. In this regard, example embodiments may have different forms and should not be construed as being limited to the descriptions set forth herein.

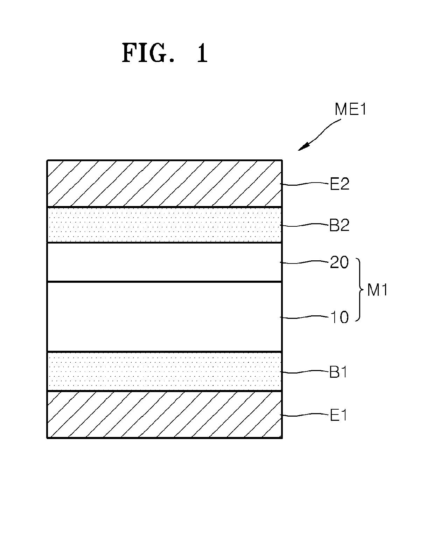

FIG. 1 is a cross-sectional diagram of nonvolatile memory elements ME1 according to example embodiments. Referring to FIG. 1, a nonvolatile memory element ME1 (referred to hereinafter as a memory element, ME1) according to an example embodiment may include a memory layer M1 with a multi-layer structure. The memory element ME1 may be between first and second electrodes E1 and E2. The memory layer M1 may be a double layer structure including a first material layer 10 and a second material layer 20, for example. The memory layer M1 may exhibit resistance change characteristics due to movement of ion species between the first material layer 10 and the second material layer 20.

A first buffer layer B1 may be between the memory layer M1 and the first electrode E1. The first buffer layer B1 may be between the first material layer 10 and the first electrode E1. A second buffer layer B2 may be between the memory layer M1 and the second electrode E2. The second buffer layer B2 may be between the second material layer 20 and the second electrode E2. The presence of the first and second buffer layers B1 and B2 may improve reliability, reproducibility, and stability of resistive switching in the memory element ME1.

The first material layer 10 of the memory layer M1 may be, for example, a first metal oxide. For example, the first metal oxide may include a Ta oxide, a Zr oxide, an yttria-stabilized zirconia (YSZ), a Ti oxide, a Hf oxide, a Mn oxide, a Mg oxide and/or a combination thereof. If the first metal oxide includes a Ta oxide, the first metal oxide may be TaOₓ (where, x may be in a range of 0 < x < 2.5 or 0.5 ≤ x ≤ 2.0). Oxygen ions and/or oxygen vacancies may exist within the first material layer 10. The first material layer 10 may be referred to as an "oxygen reservoir layer." The thickness of the first material layer 10 may be, for example, about 1 nanometer (nm) to about 100 nm. The thickness of the first material layer 10 may be, for example, about 5 nm to about 50 nm.

The second material layer 20 may exchange oxygen ions and/or oxygen vacancies with the first material layer 10 to change the resistance of the memory layer M1. The second material layer 20 may be referred to as an "oxygen exchange layer." The second material layer 20 may be, for example, a second metal oxide. The second material layer 20 may be of the same group as or different group from the first metal oxide. For example, the second metal oxide may include a Ta oxide, a Zr oxide, an YSZ, a Ti oxide, a Hf oxide, a Mn oxide, a Mg oxide and/or a combination thereof. The second metal oxide may have a stoichiometric composition or a similar composition thereto (e.g., near stoichiometric). For example, when the second metal oxide includes a Ta oxide, the Ta oxide may be a Ta₂O₅ layer or a layer having a composition similar to Ta₂O₅.

Similarly to the first material layer 10, the second material layer 20 may also include oxygen ions and/or oxygen vacancies. The oxygen mobility (or oxygen diffusivity) of the second material layer 20 may be equal to or greater than that of the first material layer 10. The resistivity of the second material layer 20 may be different from that of the first material layer 10. For example, the resistivity of the second material layer 20 may be greater than that of the first material layer 10. The resistance of the memory layer M1 may be determined by the resistance of the first material layer 10 in the ON state. The ON state may be a state in which a current path may be formed in the second material layer 20. The resistance of the memory layer M1 may be determined by the resistance of the second material layer 20 in the OFF state. The OFF state may be a state in which no current path may be formed in the second material layer 20. The oxygen concentration of the second material layer 20 may be greater than that of the first material layer 10.

Although example embodiments are described herein with reference to two ion conduction layers (e.g., first and second material layers 10 and 20), example embodiments are not limited thereto. For example, a third ion conduction layer may be included. For example, a memory layer M1 may include a stoichiometric oxide, a near stoichiometric oxide and a nonstoichiometric oxide. As another example, the memory layer M1 may include a material or material structure (e.g., an oxide structure) in which the oxygen concentration in the memory layer M1 decreases from one end to another (e.g., in a depth direction).

The oxygen concentration of the second material layer 20 may not be greater than that of the first material layer 10. When the second material layer 20 and the first material layer 10 include the same metal oxide, the oxygen concentration of the second material layer 20 may be higher than that of the first material layer 10. When the second material layer 20 and the first material layer 10 include different metal oxides, the oxygen concentration of the second material layer 20 may not always be higher than that of the first material layer 10. The thickness of the second material layer 20 may be, for example, about 1 nm to about 50 nm. The thickness of the second material layer 20 may be, for example, about 5 nm to about 20 nm. The thickness of the second material layer 20 may be less than that of the first material layer 10. The resistance change characteristics (e.g., switching speed and/or ON/OFF ratio) of the memory element ME1 may vary according to material properties of the second material layer 20 (e.g., the oxygen exchange layer).

According to at least one example embodiment, the first and second buffer layers B1 and B2 may improve reliability, reproducibility, and stability of switching in the memory layer M1. The first and second buffer layers B1 and B2 may include a material with an interatomic bonding energy which may be greater than that of the memory layer M1. The interatomic bonding energy of the first buffer layer B1 may be greater than the interatomic bonding energy (e.g., Ta-O) in the first material layer 10. An affinity of the first buffer layer B1 to at least one of an ion and an ion vacancy conducted by the first material layer 10 may be less than the affinity of the first electrode E1 to at least one of the ion and the ion vacancy. According to at least one example embodiment, the first buffer layer B1 may be impermeable to at least one of the ion and the ion vacancy.

The interatomic bonding energy of the second buffer layer B2 may be greater than the interatomic bonding energy of the second material layer 20. An affinity of the second buffer layer B2 to at least one of an ion and an ion vacancy conducted by the second material layer 20 may be less than the affinity of the second electrode E2 to the at least one of the ion and the ion vacancy. According to at least one example embodiment, the second buffer layer B2 may be impermeable to at least one of the ion and the ion vacancy. In regard to the bonding energy, the material forming the first and second buffer layers B1 and/or B2 may be more stable than the material constituting the memory layer M1.

The first and second buffer layers B1 and B2 may include a material that increases potential barriers between the first electrode E1 and the memory layer M1, and between the second electrode E2 and the memory layer M1, respectively. A conduction band offset between the first buffer layer B1 and the first electrode E1 may be greater than a conduction band offset between the first material layer 10 and the first electrode E1. A band gap of the first buffer layer B1 may be greater than a band gap of the first material layer 10. A conduction band offset between the second buffer layer B2 and the second electrode E2 may be greater than a conduction band offset between the second material layer 20 and the second electrode E2. A band gap of the second buffer layer B2 may be greater than a band gap of the second material layer 20. The first and second buffer layers B1 and B2 may include a material that allows the first and second buffer layers B1 and B2 to suppress excessive current flows between the first electrode E1 and the first material layer 10 and between the second electrode E2 and the second material layer 20, respectively.

According to at least one example embodiment, excessive current flow may be suppressed by a conduction band offset and/or by including, in the first and second buffer layers B1 and B2, a material with a greater resistivity than that of the material of the memory layer M1. According to at least one example embodiment, the first and second buffer layers B1 and B2 may include AlOₓ, SiOₓ, SiNₓ, ZrOₓ, HfOₓ and/or a combination thereof. The first and second buffer layers B1 and B2 may have stoichiometric compositions, but not always. Each of the first and second buffer layers B1 and B2 may be of a suitable composition and thickness to allow current flow while functioning as a buffer. For instance, the thickness of each of the first and second buffer layers B1 and B2 may be less than about 10 nm. When the first and second buffer layers B1 and B2 include stoichiometric compositions, the thickness of each of the first and second buffer layers B1 and B2 may be less than about 5 nm.

If each of the first and second buffer layers B1 and B2 is too thick, an insulation characteristic of the buffer layer may be too high and/or increased. A suitable thickness of each of the first and second buffer layers B1 and B2 may be less than about 10 nm. According to at least one example embodiment, the first and second electrodes E1 and E2 may include, for example, a non-precious metal (e.g. Ti, Ta, TiN, TiW, TaN, W, Ni, and/or the like), a relatively inexpensive precious metal (e.g. Ru), and/or an alloy thereof. The first and second electrodes E1 and E2 may include, for example, a conductive oxide. The conductive oxide may be a ZnO-based oxide (e.g. indium zinc oxide, IZO), and/or a SnO-based oxide (e.g. indium tin oxide, ITO), and/or the like. According to example embodiments, a stable and/or improved memory characteristic may be secured without the first and second electrodes E1 and E2 including an expensive precious metal by employing the first and second buffer layers B1 and B2 in a nonvolatile memory element ME1.

If the first and second electrodes E1 and E2 are formed of an expensive precious metal with relatively low reactivity, it may not be necessary to include the first and second buffer layers B1 and B2. However, the use of expensive precious metals may increase the cost of fabrication of the memory element. The use of the first and second electrodes E1 and E2 of an expensive precious metal, without employing the first and second buffer layers B1 and B2, may not secure reproducibility and stability of a resistance change characteristic in the memory element. According to at least one example embodiment, the use of the first and second buffer layers B1 and B2 alone may secure reproducibility and stability of the memory characteristic.

The first and second electrodes E1 and E2 may include an inexpensive material without sacrificing the reproducibility and stability of the memory characteristic. Even though it may not be necessary, precious metals may be included in the first and second electrodes E1 and E2. When it may be desired or necessary, the first and second electrodes E1 and E2 may include a precious metal (e.g. Pt, Ir, Pd, Au and/or the like). The first and second electrodes E1 and E2 may include Pt, Ir, Pd, Au, Ru, Ti, Ta, TiN, TiW, TaN, W, Ni, a conductive oxide, and/or an alloy thereof. The first and second electrodes E1 and E2 may include various electrode materials which are generally used in fields related to semiconductor devices. The first and second barrier layers B1 and B2 may prevent and/or reduce a reaction between a memory layer M1 and layers including reactive materials, for example, first and second electrodes E1 and E2.

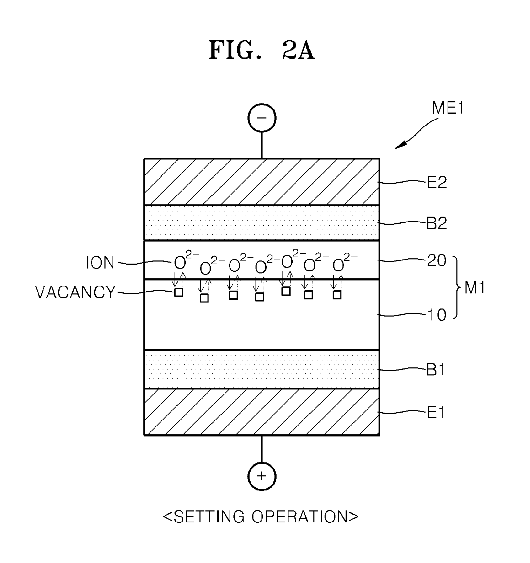

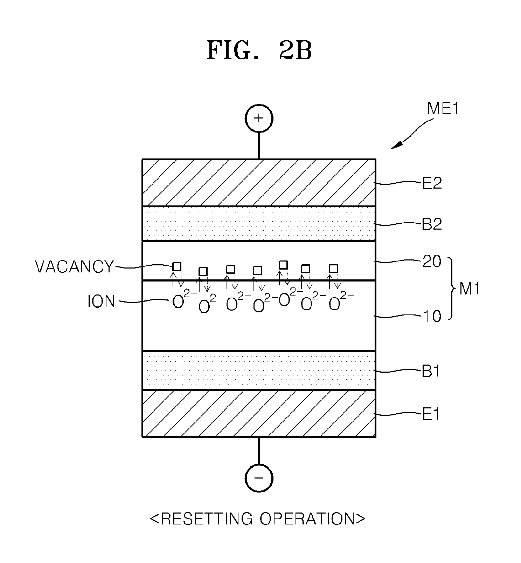

FIGS. 2A and 2B are schematic views illustrating the operation mechanism of a memory cell according to at least one example embodiment. Referring to FIG. 2A, a positive (+) voltage may be applied to the first electrode E1 and a negative (-) voltage may be applied to the second electrode E2 during a set operation. Oxygen vacancies may move from the first material layer 10 to the second material layer 20. A current path (not shown) may be formed in the second material layer 20. An oxygen content of the second material layer 20 may decrease. The resistance of the memory layer M1 may decrease and the memory layer M1 may be switched from the OFF state to the ON state. In this set operation, oxygen ions may move in a direction opposite to the moving direction of the oxygen vacancies. Oxygen ions may move from the second material layer 20 to the first material layer 10.

As shown in FIG. 2B, a negative (-) voltage may be applied to the first electrode E1 and a positive (+) voltage may be applied to the second electrode E2 during a reset operation. Oxygen vacancies may move from the second material layer 20 to the first material layer 10 and oxygen ions may move from the first material layer 10 to the second material layer 20. An oxygen content of the second material layer 20 may increase. The current path (not shown) formed in the second material layer 20 may be broken. The resistance of the memory layer M1 may increase and the memory layer M1 may switch from the ON state to the OFF state.

Although example embodiments are described herein with respect to a current path, example embodiments are not limited thereto. For example, a change in oxygen content of the first material layer 10 or the second material layer 20 may generally decrease or increase a resistance of the memory layer M1. As one example, a resistance of an oxygen deficient second material layer 20 may be less than a resistance of a stoichiometric second material layer 20.

According to example embodiments, the first and second buffer layers B1 and B2 may improve reliability, reproducibility and stability of resistance change characteristics during the set/reset operations. Without the first and second buffer layers B1 and B2, oxygen ions and/or oxygen vacancies that are a part of the resistance change mechanism may move toward the electrodes E1 and E2 during the set/reset operations. The oxygen ions and oxygen vacancies may physically/chemically react with the electrodes E1 and E2, and/or the memory layer M1 may physically/chemically react with the electrodes E1 and E2 due to the movement of the oxygen ions/vacancies. Reliability, reproducibility, and stability of resistive switching may decrease as resistance change characteristics deteriorate. For example, a breakdown phenomenon may occur, in which current rapidly increases between the first electrode E1 and the second electrode E2.

An undesired material layer may be formed at interfaces between the memory layer M1 and the first electrode E1, and between the memory layer M1 and the second electrode E2. Resistance change characteristics of the memory element may deteriorate. The deterioration may be greater when the first and second electrodes E1 and E2 include one or more inexpensive non-precious metals. Repetitive switching operations between the ON and OFF states may increase the probability that the mechanisms causing deterioration of memory characteristics will occur.

When a TaOₓ layer is used as a resistance changing material in the memory layer M1, the resistance change characteristics may significantly vary based on a method of formation, deposition conditions and oxygen content of the TaOₓ layer. It may be difficult to reliably maintain the resistance change characteristics of the memory layer M1. According to at least one example embodiment, deterioration of the resistance characteristics may be suppressed, prevented and/or decreased while improving and/or securing the reliability, reproducibility, and stability of resistance change characteristics by forming the first buffer layer B1 between the first electrode E1 and the memory layer M1, and by forming the second buffer layer B2 between the second electrode E2 and the memory layer M1.

The first buffer layer B1 may suppress, prevent or reduce a chemical reaction between the first electrode E1 and the first material layer 10 or between the first electrode E1 and the ionic species of the first material layer 10 during the initial set operation (e.g., the forming process). The first buffer layer B1 may further contribute to prevention of a reaction between the first material layer 10 and the first electrode E1 during the formation process of the first material layer 10. Similarly, the second buffer layer B2 may suppress, prevent or reduce a chemical reaction between the second electrode E2 and the second material layer 20 or between the second electrode E2 and the ionic species of the second material layer 20. For example, the second buffer layer B2 may suppress, prevent or reduce movement of an excessive and/or increased amount of oxygen vacancies toward the second electrode E2 during a set operation.

According to example embodiments, the first and second electrodes E1 and E2 may include a precious metal, an inexpensive non-precious metal and/or a conductive oxide when the first and second buffer layers B1 and B2 are employed. Without introducing the buffer layers B1 and B2, it may be difficult to form the first and second electrodes E1 and E2 using a non-precious metal and/or a conductive oxide with high reactivity. The use of a precious metal for the first and second electrodes E1 and E2 may increase fabrication costs and place some limitations on the fabricating processes used in manufacturing a memory element. When the first and second electrodes E1 and E2 include a non-precious metal and/or a conductive oxide instead of a precious metal, the cost of fabrication may decrease and there may be fewer limitations with respect to the fabrication processes.

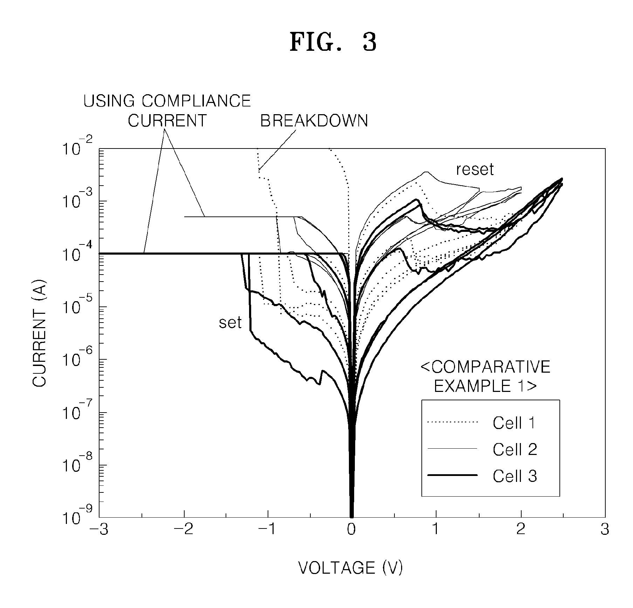

FIG. 3 is a graph illustrating voltage-current characteristics of memory elements with a Pt/TaOₓ/Ta₂O₅/Pt structure according to a comparative example 1. The graph of FIG. 3 is a result of switching each of 3 memory cells 3 times during a DC sweep mode. The memory element according to the comparative example 1 may employ an electrode formed of a precious metal (Pt) and may not include a buffer layer. In the memory element of the comparative example 1, TaOₓ and Ta₂O₅ may correspond to the first material layer 10 and the second material layer 20 of an example embodiment (e.g., as shown in FIG. 1), respectively, and the lower and upper Pt layers may be electrodes corresponding to the first electrode E1 and the second electrode E2, respectively.

Referring to FIG. 3, nonuniformity of resistance change characteristics between cells may be noticeable. Within a same cell, the distribution of ON and OFF currents may vary according to the number of measurements. The amount of current flowing into the memory element may rapidly increase and result in an insulation breakdown during a set operation if there is no adjustment of the amount of current flowing into the memory element by using a suitable level of compliance current. Switching operations of the memory element according to the comparative example 1 may not be reliable, reproducible, and/or stable due to variation in the memory characteristics of the memory element, and it may not be possible to repeat ON/OFF driving operations over a (relatively) long period of time with a normal driving pulse.

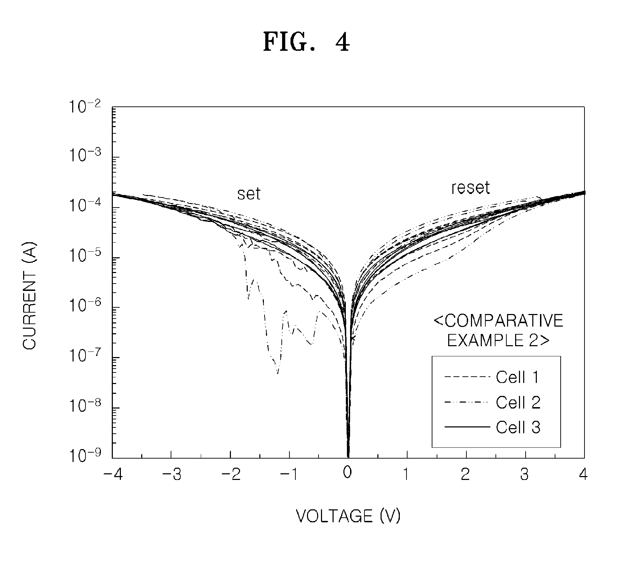

FIG. 4 is a graph illustrating voltage-current characteristics of memory elements with a W/Al₂O₃/TaOₓ/Ta₂O₅/Ru structure according to a comparative example 2. The graph of FIG. 4 is a result of switching each of 3 memory cells 3 times during a DC sweep mode. The memory element according to comparative example 2 may include a buffer layer only on the lower side of the memory element, and a Ru electrode may be on the upper side of the memory element without including a buffer layer. The TaOₓ and Ta₂O₅ of comparative embodiment 2 may correspond to the first material layer 10 and the second material layer 20 of an example embodiment (e.g., as shown in FIG. 1), respectively.

Referring to FIG. 4, the nonuniformity of resistance change characteristics between cells may be noticeable similarly to the resistance change characteristics of the comparative example 1 of Fig. 3. The distribution of ON and OFF currents may also vary noticeably based on the number of measurements. Switching operations of the memory element including a buffer layer in only one side may not be reliable, reproducible, and/or stable due to variation in the memory characteristics of the memory element.

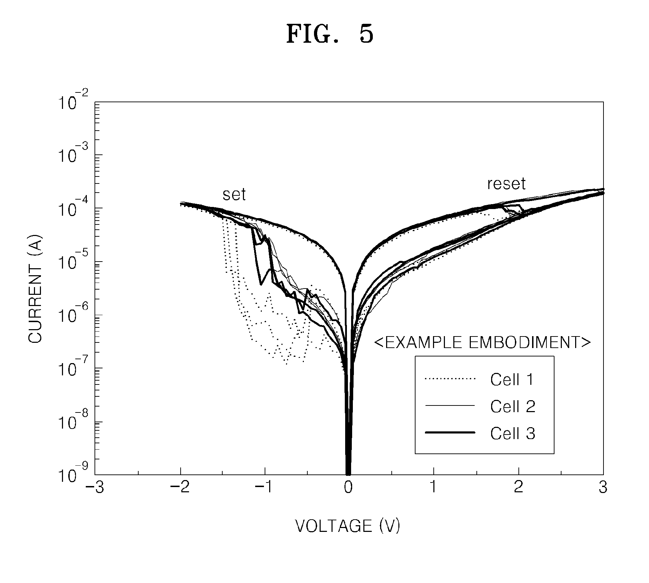

FIG. 5 is a graph illustrating voltage-current characteristics of memory elements according to at least one example embodiment. The graph of FIG. 5 is a result of switching each of three memory cells 3 times during a DC sweep mode. A structure of the memory elements according to the at least one example embodiment may be a W/Al₂O₃/TaOₓ/Ta₂O₅/Al₂O₃/Ru structure with a configuration illustrated in FIG. 1. The first electrode E1 and the second electrode E2 of the memory element may be formed of W and Ru, respectively. The memory element may include first and second Al₂O₃ buffer layers B1 and B2, respectively. The first material layer 10 and the second material layer 20 may be TaOₓ and Ta₂O₅, respectively.

Referring to FIG. 5, the uniformity of the resistance change characteristics between cells may be improved in the memory element according to at least one example embodiment as compared to resistance change characteristics of comparative examples 1 and 2, as illustrated in FIGS. 3 and 4. In Fig. 5, it may be noticeable that stable resistance change characteristics (i.e., bipolar memory switching characteristics) may be obtained, and a rapid increase of the amount of current, which may cause a breakdown phenomenon, may be suppressed, prevented and/or reduced without using a compliance current during a set operation. Stable resistance change characteristics may be exhibited in a memory element according to at least one example embodiment even though the electrodes may include relatively inexpensive materials (e.g., W and Ru).

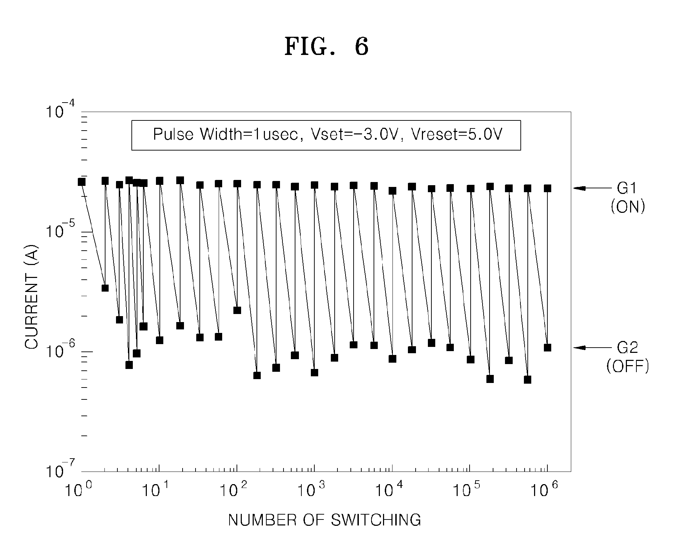

FIG. 6 is a graph illustrating ON and OFF current as a function of a number of switching operations of a memory element according to at least one example embodiment with a W/Al₂O₃/TaOₓ/Ta₂O₅/Al₂O₃/Ru structure and resistance change characteristics as illustrated in FIG. 5. FIG. 6 is a result of measuring current in a memory element according to at least one example embodiment in an AC sweep mode. In FIG. 6, the first points G1 may indicate a variation of the ON current and the second points G2 may indicate a variation of the OFF current, with respect to the number of switching operations. Referring to FIG. 6, the resistance change characteristics of the memory element may be relatively stable after repeating ON/OFF switching operations more than 10⁶ times.

Memory elements according to example embodiments may be applied to memory devices with various structures. The memory device may further include a switching element connected to the memory element.

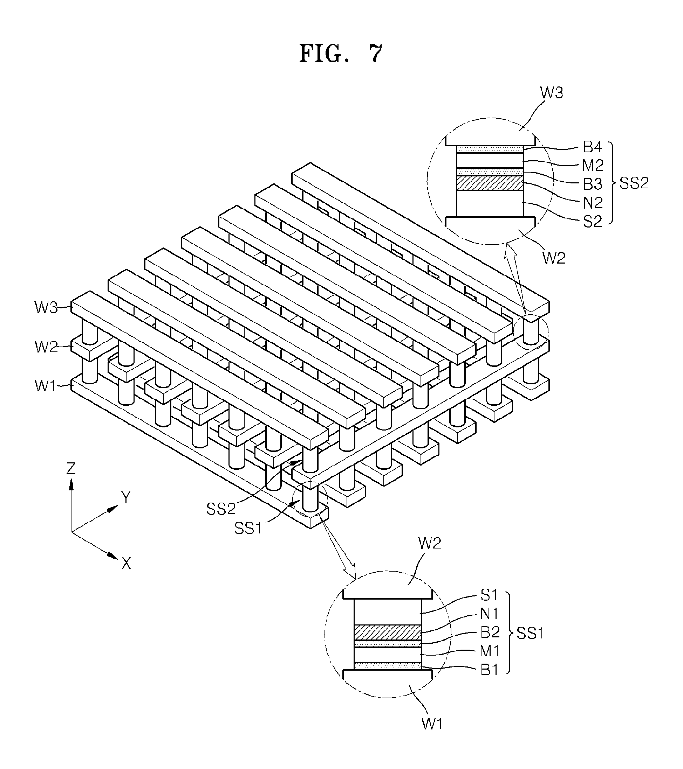

FIG. 7 is a perspective view of a memory device including a memory element according to further example embodiments. The memory device illustrated in Fig. 7 may be a cross point resistive-type memory device. Referring to FIG. 7, a plurality of first wirings W1 may extend in a first direction (e.g. the x-axis direction) and may be parallel to each other. A plurality of second wirings W2 may extend a second direction (e.g. the y-axis direction) crossing the first direction. The first stacked structures (first memory cells) SS1 may be at points at which the first wiring W1 and the second wiring W2 cross. A first stacked structure SS1 may include a first buffer layer B1, a first memory layer M1, a second buffer layer B2, a first intermediate electrode N1 and a first switching element S1 stacked on the first wiring W1. In the first stacked structure SS1, the lower structure including B1+M1+B2 may be below the first intermediate electrode N1, and the upper structure including S1 may be above the first intermediate electrode N1. The locations of the upper structure and the lower structure may be switched with respect to the first intermediate electrode N1.

The first buffer layer B1, the first memory layer M1, and the second buffer layer B2 of the first stacked structure SS1 may correspond respectively to the first buffer layer B1, the memory layer M1, and the second buffer layer B2 of the memory element shown in FIG. 1. The first switching element S1 may be a two-way/bidirectional diode, a threshold switching device, a varistor and/or the like. When the first switching device S1 is a two-way diode, the two-way diode may be, for example, an oxide diode. If a silicon diode is employed for the switching device, a high temperature process (e.g. at about 800°C) may be necessary to form the silicon diode. This high temperature requirement may place some restrictions on the selection of a substrate and may cause various other problems. There may be some advantages in using an oxide layer for the first switching element S1 because an oxide layer may be formed (e.g., easily formed) at room temperature.

Although the use of silicon may cause some processing difficulties, the silicon material may not be excluded from the list of potential materials used in the first switching element S1. The first switching element S1 may be a silicon switching element and/or a switching element made of other qualified materials according to necessity. The first wiring W1 and the first intermediate electrode N1 may correspond to the first electrode E1 and the second electrode E2 of FIG. 1, respectively. At least one of the first wiring W1 and the first intermediate electrode N1 may include Pt, Ir, Pd, Au, Ru, Ti, Ta, TiN, TiW, TaN, W, Ni, a conductive oxide, and/or an alloy thereof. The second wiring W2 may or may not be of the same material as the first wiring W1.

Third wirings W3 may be spaced apart from top surfaces of the second wirings W2. The third wings W3 may be parallel to each other and spaced apart by an interval. The third wirings W3 may cross the second wirings W2 and may be spaced apart by a same interval. The second stacked structures (second memory cells) SS2 may be at points where one of the second wirings W2 and one of the third wirings W3 cross. Each of the second stacked structures SS2 may have a reverse structure of the first stacked structure SS1 or an identical structure of the first stacked structure SS1. Each of the second stacked structures SS2 may include a second switching element S2, a second intermediate electrode N2, a third buffer layer B3, a second memory layer M2, and a fourth buffer layer B4, which may be stacked on the second wiring W2. In the second stacked structure SS2, the lower structure including S2 may be below the second intermediate electrode N2, and the upper structure including B3+M2+B4 may be above the second intermediate electrode N2. The locations of the upper structure and the lower structure may be switched with respect to the second intermediate electrode N2.

The third and fourth buffer layers B3 and B4 may include the same material used for the first and second buffer layers B1 and B2. A structure of the second memory layer M2 may be the same as the structure of the memory layer M1 (e.g., as illustrated in FIG. 1) in the same order or in a reversed/mirror-image order. The second switching element S2 may have a reverse structure of the first switching element S1 or the same structure as the first switching element S1. The switching direction of the second switching element S2 may be opposite to or the same as that of the first switching element S1. The third wirings W3 and the second intermediate electrode N2 may correspond to the first electrode E1 and the second electrode E2 of FIG. 1, respectively, or may correspond to the second electrode E2 and the first electrode E1 of FIG. 1, respectively. At least one of the third wiring W3 and the second intermediate electrode N2 may include Pt, Ir, Pd, Au, Ru, Ti, Ta, TiN, TiW, TaN, W, Ni, a conductive oxide and/or an alloy thereof.

Although the first and second stacked structures SS1 and SS2 are illustrated as being cylindrically shaped in FIG. 7, the first and second stacked structures SS1 and SS2 may be various other shapes. For example the first and second stacked structures SS1 and SS2 may square-pillar-shaped or pillar-shaped with a downward increasing width. The first and second stacked structures SS1 and SS2 may be asymmetrically shaped. For example, the first and/or second stacked structures may include a section with a cross-sectional area that is larger than an area of the cross-points formed by the neighboring wirings (e.g. W1 and W2 or W2 and W3). It is also possible that the first and/or second stacked structure may include a portion with a center that is off from the center of the cross-point formed by the neighboring wirings. The shape of the memory device shown in Fig. 7 may be further modified within the spirit and scope of example embodiments.

Although not shown, the resistive memory device shown in FIG. 7 according to an example embodiment may include a stacked structure that is the same or similar to the stacked structure including the first stacked structures SS1 and the second wirings W2, on the third wirings W3. A resistive memory device according to an example embodiment may include at least one set of a stacked structure that may be the same or similar to the stacked structure including the first stacked structures SS1, the second wirings W2, the second stacked structures SS2, and the third wirings W3, on the third wirings W3. A resistive memory device according to an example embodiment may include at least one set of a stacked structure that may be the same or similar to the stacked structure including the first stacked structures SS1, the second wirings W2, the second stacked structures SS2, the third wirings W3, the first stacked structures SS1, and the second wirings W2, which may be sequentially stacked, on the third wirings W3.

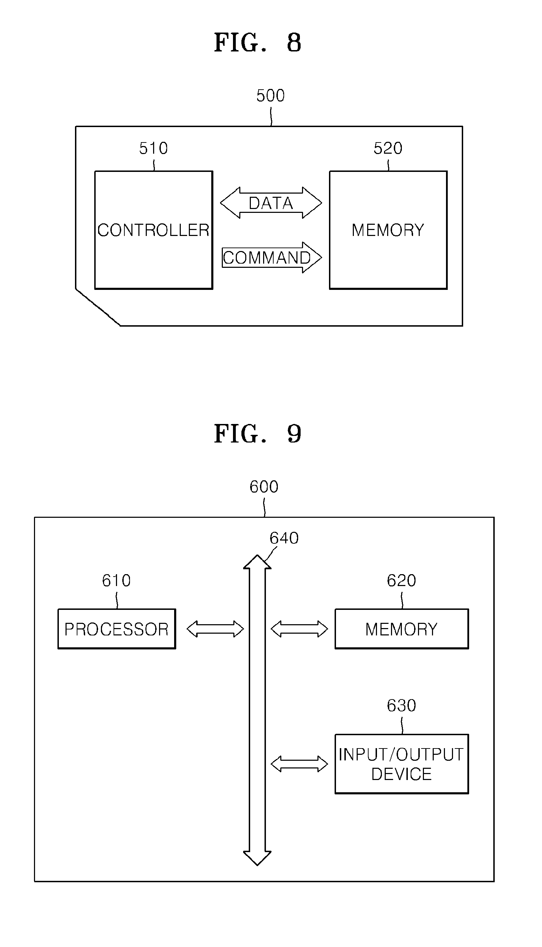

FIG. 8 is a schematic diagram illustrating a memory card 500 according to an example embodiment. Referring to FIG. 8, a controller 510 and a memory 520 may exchange electric signals. For example, according to commands of the controller 510, the memory 520 and the controller 510 may exchange data. The memory card 500 may either store data in the memory 520 or output data from the memory 520. The memory 520 may include one of the non-volatile memory elements described above with reference to FIGS. 1-7. A memory card 500 may be used as a storage medium for various portable electronic devices. For example, the memory card 500 may be a multimedia card (MMC) and/or a secure digital (SD) card.

FIG. 9 is a block diagram illustrating an electronic system 600 according to an example embodiment. Referring to FIG. 9, a processor 610, an input/output device 630, and a memory 620 may perform data communication with each other by using a bus 640. The processor 610 may execute a program and control the electronic system 600. The input/output device 630 may be used to input/output data to/from the electronic system 600. The electronic system 600 may be connected to an external device (e.g. a personal computer and/or a network) by using the input/output device 630 and may exchange data with the external device.

The memory 620 may store code and/or programs for operations of the processor 610. For example, the memory 620 may include one of the non-volatile memory elements described above with reference to FIGS. 1-7. For example, an electronic system 600 may embody various electronic control systems requiring the memory 620, and, for example, may be used in mobile phones, MP3 players, navigation devices, solid state disks (SSD), and/or household appliances.

While example embodiments have been particularly shown and described, it will be understood by one of ordinary skill in the art that variations in form and detail may be made therein without departing from the scope of the claims.

## Claims

1. A nonvolatile memory element, comprising:
a first electrode;
a second electrode;
a memory layer with a resistance change characteristic between the first and
second electrodes;
a first buffer layer between the first electrode and the memory layer; and
a second buffer layer between the second electrode and the memory layer,
wherein:
the memory layer includes first and second material layers;
the first material layer includes a first metal oxide, and
the second material layer includes a second metal oxide.

2. The nonvolatile memory element of claim 1, wherein
the resistance change characteristic of the memory layer is based on movement of at least one ionic species between the first and second material layers.

3. The nonvolatile memory element of claim 1 or 2, wherein the first metal oxide includes at least one of a Ta oxide, a Zr oxide, an yttria-stabilized zirconia (YSZ), a Ti oxide, a Hf oxide, a Mn oxide, a Mg oxide, and a combination thereof.

4. The nonvolatile memory element of claim 3, wherein the first metal oxide includes TaOₓ, where 0 < x < 2.5.

5. The nonvolatile memory element of any of claims 1-4, wherein the second metal oxide includes at least one of a Ta oxide, a Zr oxide, an yttria-stabilized zirconia (YSZ), a Ti oxide, a Hf oxide, a Mn oxide, a Mg oxide, and a combination thereof.

6. The nonvolatile memory element of any of claims 1-5, wherein
an oxygen concentration of a material of the second material layer is higher than an oxygen concentration of a material of the first material layer, and/or oxygen mobility in the material of the second material layer is greater than or equal to oxygen mobility in the material of the first material layer.

7. The nonvolatile memory element of any of claims 1-6, wherein:
a thickness of the first material layer is about 1 nm to about 100 nm;
a thickness of the second material layer is about 1 nm to about 50 nm; and
the thickness of the first material layer is greater than the thickness of the second material layer.

8. The nonvolatile memory element of any of claims 1-7, wherein
an interatomic bonding energy of a material included in at least one of the first and second buffer layers is greater than an interatomic bonding energy of a material included in the memory layer.

9. The nonvolatile memory element of any of claims 1-8, wherein
a conduction band offset between a material included in at least one of the first and second buffer layers and a material included in the memory layer is greater than a conduction band offset between the material included in the memory layer and a material of one of the first and second electrodes, and/or a resistivity of a material included in at least one of the first and second buffer layers is greater than a resistivity of a material included in the memory layer.

10. The nonvolatile memory element of any of claims 1-9, wherein at least one of the first and second buffer layers includes at least one of AlO_{x,} SiO_{x,} SiNₓ, ZrO_{X}, HfO_{X}, and a combination thereof,
and optionally wherein thicknesses of the first and second buffer layers are less than about 10 nm.

11. A memory device comprising at least one nonvolatile memory element of any of claims 1-10.

12. The memory device of claim 11, further comprising:
a switching element connected to the nonvolatile memory element.

13. A memory device comprising:
a plurality of first wirings;
a plurality of second wirings crossing the first wirings, a plurality of first cross-points between the first and second wirings; and
a plurality of first memory cells, each of the first memory cells being located at a respective one of the first cross-points,
wherein each of the first memory cells comprises a memory element according to any of claims 1 to 10.

14. The memory device of claim 13, wherein each of the first memory cells further comprises a switching element connected to the memory element, and an intermediate electrode between the memory element and the switching element.

15. The memory device of claim 13 or 14, further comprising:
a plurality of third wirings crossing the second wirings, a plurality of second cross-points between the second and third wirings; and
a plurality of second memory cells, each of the second memory cells being located at a respective one of the second cross-points,
and optionally wherein the second memory cell has a reverse structure of the first memory cell or an identical structure of the first memory cell.
